# FASCICULE DE BREVET EUROPEEN

(11) **EP 0 517 666 B1**
(45) Date de publication et mention de la délivrance du brevet: **04.02.1998**
(21) Numéro de dépôt: 92810414.0
(22) Date de dépôt: 29.05.1992
(51) Int. Cl.: H03H 9/19

(54) **Résonateur à quartz vibrant selon un mode fondamental de torsion**
Quarz-Resonator schwingend in einem fundementalen Drehschwingungsmode
Quartz resonator resonating in a fundamental torsional mode

(30) Priorité: 04.06.1991 CH 1654/91
(43) Date de publication de la demande: 09.12.1992
(73) Titulaire: CENTRE SUISSE D'ELECTRONIQUE ET DE MICROTECHNIQUE S.A., 2007 Neuchâtel (CH)
(72) Inventeur: Hermann, Jean, CH-2000 Neuchâtel (CH); Bourgeois, Claude, CH-2014 Bôle (CH)
(74) Mandataire: Brulliard, Joel

(56) Documents cités:
- EP-A- 0 516 400
- FR-A- 2 435 855
- GB-A- 2 124 022

## Description

La présente invention se rapporte aux résonateurs à quartz et concerne plus particulièrement les résonateurs de ce type présentant de bonnes propriétés thermiques, ayant une fréquence de résonance relativement basse, vibrant selon un mode fondamental de torsion et capable d'être produit en série par des techniques d'attaque chimique.

On connaît déjà des résonateurs satisfaisant aux conditions de faible variation de la fréquence en fonction de la température, de faible fréquence de résonance et d'usinage chimique. Des exemples peuvent être trouvés dans les références suivantes:
(1) "New Quartz Tuning Fork with Very Low Temperature Coefficient" de E. Momosaki et al, paru dans le 33ème Annual Symposium on Frequency Control (A.S.F.C.), 1979, pp. 247-254.
(2) "Vibration Analysis of Coupled Flexural Mode Tuning Fork Type Quartz Crystal Resonator" de H. Kawashima, paru dans le 42ème A.S.F.C., 1988, pp. 45-52.
(3) "A New Low Frequency Thermally Compensated Contour Mode Resonator" de C. Bourgeois, paru dans le 44ème A.S.F.C., 1990, pp. 367-371.
(4) Demande de brevet GB 2124022A.

Les trois références ci-dessus se rapportent à des résonateurs utilisant un couplage entre deux modes de vibration afin d'améliorer les propriétés thermiques. Les deux premières références concernent un diapason vibrant selon un mode de flexion couplé à un mode de torsion, tandis que la troisième référence concerne un résonateur vibrant selon un mode d'allongement couplé à un mode de flexion. Les trois exemples décrits se caractérisent par l'utilisation d'un couplage relativement serré entre les modes de vibration. Par couplage serré, on entend un écart relatif de fréquence faible (< 2%) entre les modes non couplés. Une conséquence de ce couplage serré est que les propriétés thermiques, qui en découlent, dépendent de manière critique de certaines dimensions géométriques; ce qui diminue considérablement le rendement de fabrication de tels résonateurs et en limite l'intérêt pratique.

Quant à la référence (4), elle décrit un diapason vibrant selon un mode fondamental de torsion dont un faible couplage avec un mode de flexion est utilisé pour réduire l'influence du coefficient de température du deuxième ordre.

Aussi un objet de l'invention est un résonateur à quartz présentant de bonnes propriétés thermiques, capable d'être produit en série et ne présentant pas les inconvénients des exemples de l'art antérieur décrits ci-dessus.

Un autre objet de l'invention est un résonateur à quartz dont les propriétés thermiques ne dépendent pas de manière critique de ses dimensions géométriques.

Un autre objet de l'invention est un résonateur à quartz susceptible d'être encastré.

Les caractéristiques de la présente invention sont décrites dans les revendications.

Le type de vibration choisi ne faisant appel à aucun couplage de mode, la variation de la fréquence du résonateur en fonction de la température ne dépend, en première approximation, ni du rapport dimensionnel du rectangle de base, ni de son épaisseur. L'utilisation d'une vibration hors du plan du résonateur entraîne une fréquence de vibration relativement basse; par exemple de l'ordre de 0.5 MHz pour un résonateur miniature pouvant être logé dans une encapsulation cylindrique de 2 mm de diamètre extérieur.

D'autres objets,caractéristiques et avantages de la présente invention apparaîtront à la lecture de la description suivante d'exemples de réalisation particuliers; lesdits exemples étant donnés à titre purement illustratif et en relation avec les dessins joints dans lesquels:
- la figure 1 montre un exemple de résonateur selon l'invention de forme rectangulaire avec indication des lignes nodales du mouvement et des prolongements pouvant être utilisés pour fixer le résonateur;
- la figure 2 montre le résonateur de la figure 1 muni d'un cadre de fixation;
- la figure 3 montre les angles de coupe d'une première variante de résonateur selon l'invention;
- la figure 4 montre, pour la variante de la figure 3, les lieux correspondant aux valeurs nulles du coefficient de premier ordre de température;
- la figure 5 montre les angles de coupe d'une deuxième variante de résonateur selon l'invention;
- la figure 6 montre, pour la variante de la figure 5, les lieux correspondant aux valeurs nulles de coefficient de température de premier ordre;
- la figure 7.a montre un exemple de résonateur muni de ses électrodes;

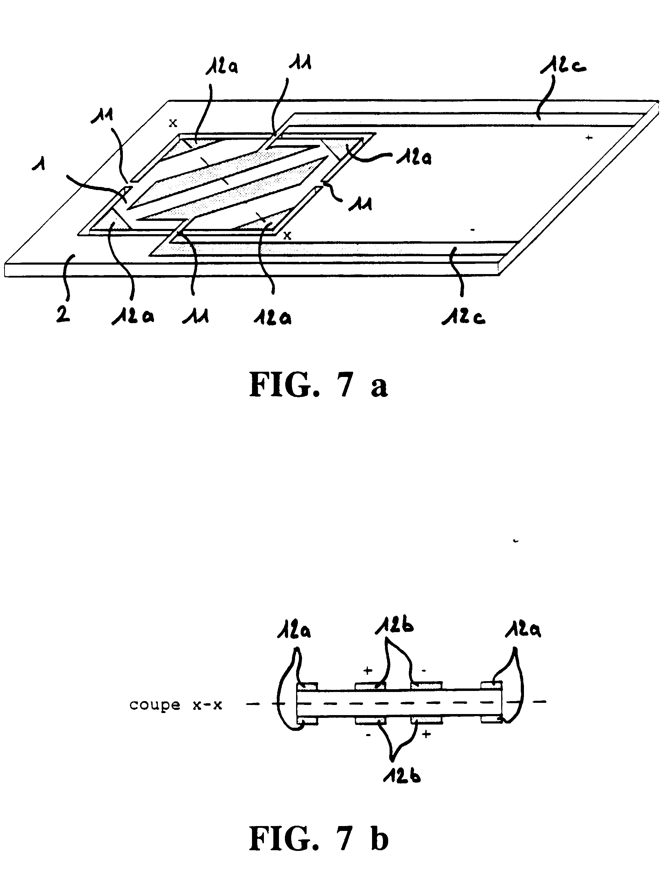

- la figure 7.b est une vue en coupe du schéma de la figure 7.a;

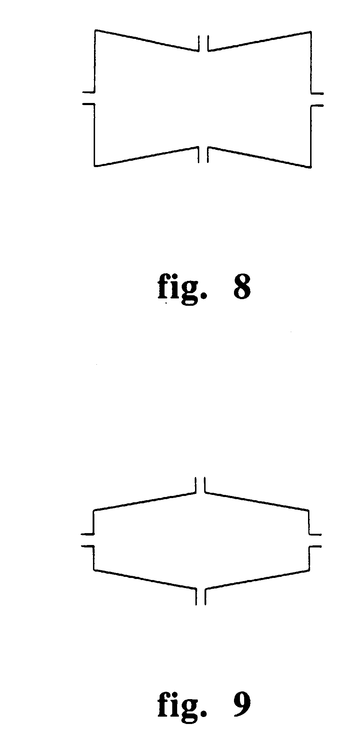

- la figure 8 montre une autre variante de résonateur selon l'invention; et
- la figure 9 montre une autre variante de résonateur selon l'invention.

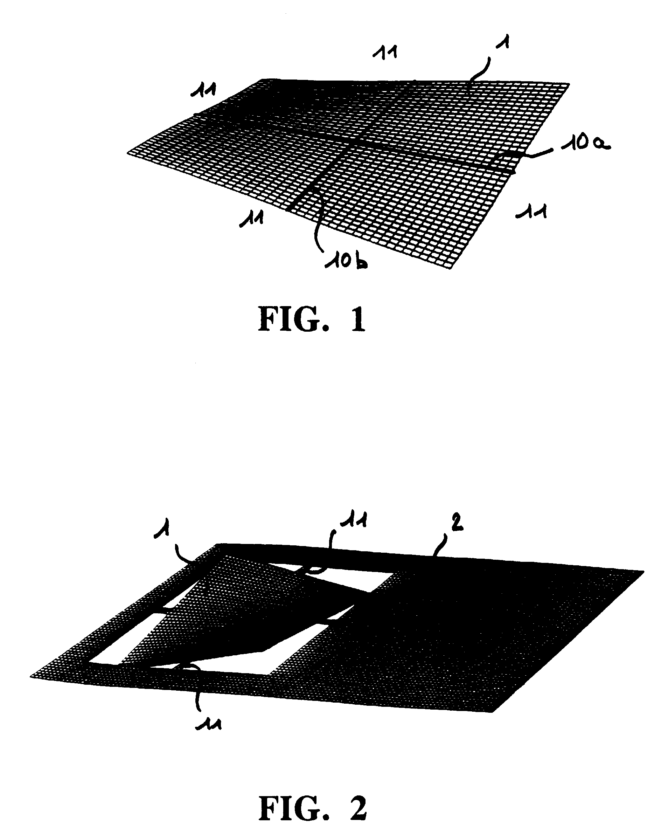

Dans un mode de réalisation préféré de l'invention, le résonateur est une plaque mince 1 de forme carrée ou rectangulaire. La figure 1 montre des lignes nodales (lieux des points sans mouvement) 10.a et 10.b dans le prolongement desquelles le résonateur peut être fixé par le biais d'un ou plusieurs bras de fixation 11. Il serait également possible de fixer le résonateur au moyen d'un fil de fixation soudé au point de croisement des lignes nodales. Toutefois, la méthode de fixation du résonateur la plus intéressante est illustrée à la figure 2 montrant le résonateur 1 de la figure 1 fixé à un cadre 2 par quatre bras 11 situés dans le prolongement des lignes nodales. Une autre solution envisageable consisterait à ne réaliser que deux bras de fixation; ceux-ci étant disposés aux extrémités opposées de la même ligne nodale. Le cadre 2 étant, de préférence, également en quartz, il est possible de fabriquer simultanément le résonateur, les bras et le cadre.

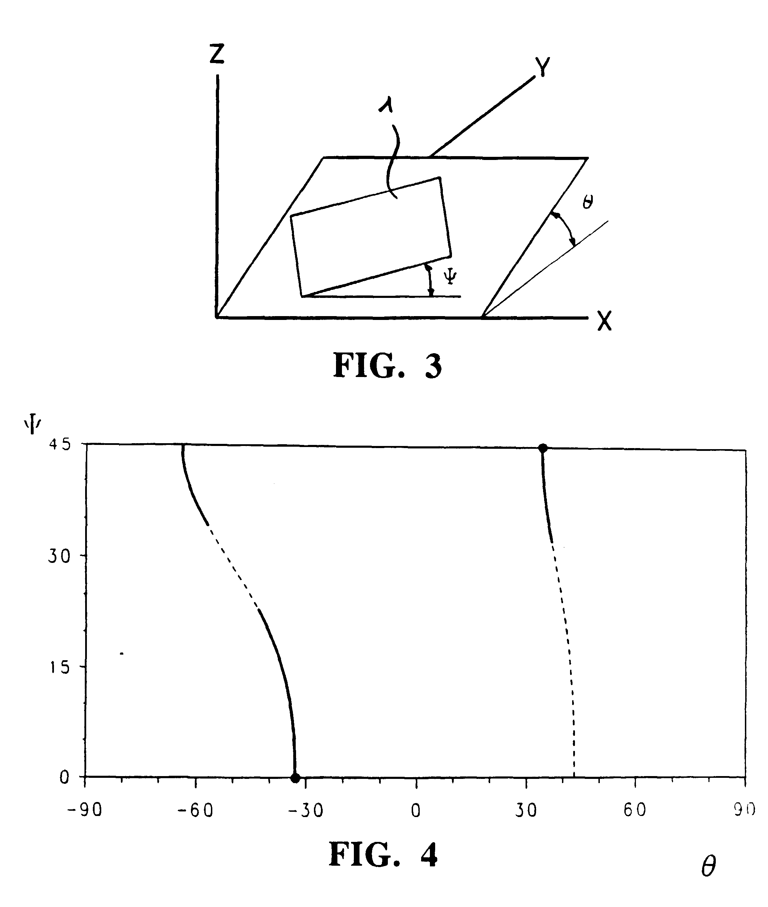

La figure 3 montre les angles de coupe d'une première variante de résonateur selon l'invention. Les axes X, Y et Z du système de référence correspondent aux axes, respectivement, électrique, mécanique et optique du cristal de quartz. Le résonateur 1 est obtenu par une première rotation d'angle Θ autour de l'axe X, suivie d'une deuxième rotation d'angle Ψ autour de la normale. Le graphe de la figure 4, représentant les lieux des valeurs nulles du coefficient de température de premier ordre ou coefficient *α,* permet de définir les valeurs possibles des angles de coupe θ et Ψ pour lesquelles le résonateur présentera de bonnes propriétés thermiques, à savoir: un coefficient de température de premier ordre α nul et un coefficient de température de deuxième ordre, ou coefficient β, nul ou de très faible valeur. Les lieux *a* = 0 sont représentés en trait plein dans les zones où le coefficient de deuxième ordre β est très faible, c'est-à-dire inférieur à une valeur d'environ 10.10 ⁻⁹ / °C² et en trait pointillé dans les autres zones.

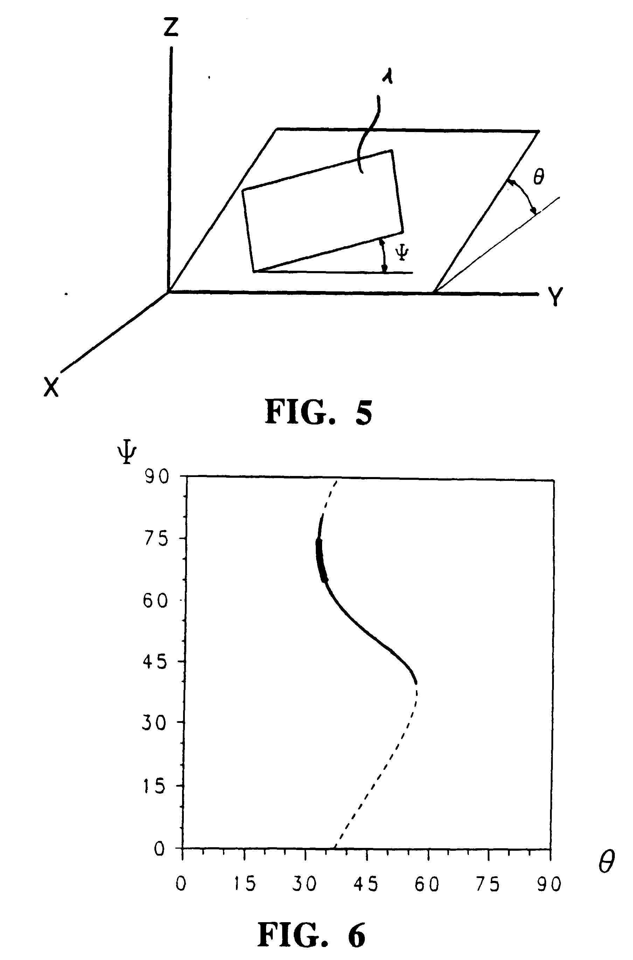

La figure 5 montre les angles de coupe d'une deuxième variante de résonateur selon l'invention. Le résonateur est obtenu par une première rotation d'angle Θ autour de l'axe Y, suivie d'une deuxième rotation d'angle Ψ autour de la normale. Le graphe de la figure 6, de manière analogue au graphe de la figure 4, montre les valeurs possibles des angles de coupe Θ et Ψ pour lesquelles le coefficient de premier ordre *a* est nul.

Il convient de noter que la rotation du substrat autour de sa normale, de même que l'orientation angulaire du résonateur, sont beaucoup plus difficiles à contrôler que la rotation proprement dite du substrat, (rotation autour de l'axe X de la figure 3 ou de l'axe Y de la figure 5). Il s'ensuit que, pour être utilisable pratiquement, une coupe doit donc remplir les deux conditions suivantes:
1) se trouver dans une zone où le coefficient de deuxième ordre β est faible;
2) la tangente au lieu α = 0 est proche de la verticale (valeur infinie).

Les trois coupes suivantes permettent de satisfaire aux deux conditions énoncées ci-dessus. Ce sont:
pour les résonateurs de la première variante,
   1) Θ = - 33° Ψ = 0°
   2) Θ = + 34° Ψ = + 45°
pour les résonateurs de la deuxième variante,
   3) Θ=33 à 35°, Ψ=65 à 75°

De plus si les résonateurs sont fabriqués à l'aide d'un procédé d'attaque chimique, par exemple en utilisant un acide fluorhydrique ou du bifluorure d'ammonium, il y a lieu de tenir compte des limites approximatives suivantes, au-delà desquelles la qualité de la découpe par voie chimique n'est plus acceptable: - 30° < Θ < + 65° pour une rotation autour de l'axe X et |Θ| < 55°. Cela signifie que, dans le cas d'une fabrication par attaque chimique, seules les coupes 2) et 3) conviennent. Il faut encore préciser que les coefficients thermiques dépendent, bien que faiblement, des éléments suivants:
- rapport dimensionnel et épaisseur relative du résonateur;
- dimensions des bras de fixation et du cadre;
- géométrie, épaisseur et matériau des zones métallisées nécessaires pour obtenir un couplage piézoélectrique et un ajustement de la fréquence du résonateur;
- constantes élastiques secondaires, qui elles-mêmes dépendent de l'orientation cristallographique choisie et peuvent légèrement modifier le mouvement global du résonateur.

Les angles de coupe permettant d'annuler les coefficients α et β et, en particulier les angles des coupes 1), 2) et 3) ci-dessus, pourront, par conséquent, s'écarter de quelques degrés des valeurs données dans les figures 4 et 6.

La figure 7 représente un mode de réalisation préféré de l'invention. Le résonateur 1 (figure 7.a) est fixé à un cadre 2 par quatre bras 11; ce qui assure la meilleure résistance aux chocs possible. Le cadre peut être lui-même fixé, par soudage ou collage, sur une base cylindrique (non représentée) munie de connexions électriques isolées. L'ensemble résonateur et base cylindrique est ensuite fermé sous vide par un capot métallique cylindrique serti de manière étanche sur la base. Deux systèmes distincts de métallisation sont représentés à la figure 7. Le premier système comprend des zones de métallisation 12.a, situées sur les deux faces du résonateur et dans chacun des coins de la plaque rectangulaire, qui ne sont pas connectées à l'extérieur. Le rôle de ce premier système de métallisation est de permettre, aprés fabrication, un ajustement de la fréquence du résonateur par vaporisation sélective du métal à l'aide d'un faisceau laser. Cette opération, nécessaire compte tenu des tolérances de fabrication, permet d'obtenir la fréquence de consigne. Un ajustement grossier peut être fait directement sur le substrat et l'ajustement fin lorsque le résonateur est monté sur sa base. Le deuxième système de métallisation comprend, sur chaque face, un jeu d'électrodes bipolaires 12.b qui permet d'obtenir le couplage piézoélectrique nécessaire à l'excitation du mode de vibration de torsion. Les électrodes 12.b sont réalisées dans la partie centrale du résonateur, elles sont alignées sur une droite dont l'inclinaison dépend de la coupe cristallographique choisie. La coupe de la figure 7.b montre l'inversion de polarité des électrodes 12.b sur les deux faces du résonateur. Les électrodes 12.b sont reliées aux connexions électriques de la base de montage par l'intermédiaire de pistes métallisées 12.c sur le cadre extérieur et la zone de collage/soudage.

Dans un exemple de réalisation particulier, les caractéristiques d'un résonateur tel que représenté à la figure 7 sont les suivantes:
- fréquence: 524 kHz
- coupe: Θ = + 34°; Ψ = + 45°
- inclinaison des électrodes: 45°
- épaisseur: 80 µm
- plaque carrée: 0.75 x 0.75 mm²
- dimensions hors-tout: 1.2 x 2.3 mm².

Différentes variantes, correspondant à des modifications plus ou moins importantes des exemples décrits, peuvent être envisagées. La géométrie simple carrée ou rectangulaire, telle que représentée, n'est pas la seule géométrie qui permette la mise en oeuvre du mode de torsion caractéristique de l'invention. On peut envisager notamment des formes carrées ou rectangulaires modifiées telles que représentées aux figures 8 et 9 ou encore des parallélogrammes, des cercles ou des ellipses (non représentés). De telles modifications peuvent affecter sensiblement les propriétés thermiques, en particulier le coefficient thermique de deuxième ordre. Ces modifications peuvent également, selon les cas, impliquer une variation des angles de coupe cristallographiques de quelques degrés. De manière analogue, les électrodes de couplage peuvent être modifiées en incorporant, par exemple, des parties non rectilignes. La forme des électrodes dépend de la forme choisie pour le résonateur. Les différentes variantes de résonateur représentées montrent, chacune, deux couples de bras de liaison résonateur-cadre opposés. Cependant comme mentionné précédemment, il est possible de supprimer l'un des deux couples pour diminuer l'effet perturbateur du cadre extérieur sur le résonateur central. Il s'ensuivra, dans ce cas, une moindre résistance aux chocs. De plus, des entailles peuvent être prévues entre le cadre et la zone de montage proprement dite en vue d'augmenter le facteur de qualité et de réduire l'influence du montage sur la base du résonateur.

## Revendications

1. Résonateur à quartz (1) ayant une forme géométrique symétrique réalisée dans une plaque mince (1,2) et présentant de bonnes propriétés thermiques, ladite plaque mince étant obtenue par une rotation d'angle Θ autour de l'axe électrique X du cristal de quartz et l'axe de symétrie de ladite forme géométrique faisant avec ledit axe X un angle Ψ, lesdits angles Θ et Ψ étant choisis de telle manière que le coefficient thermique de premier ordre a ait une valeur nulle ou voisine de zéro et le coefficient thermique de deuxième ordre β ait une valeur nulle ou très faible; ledit résonateur étant caractérisé en ce que :
- il présente une forme pleine et symétrique insérée dans un cadre (2) formé par ladite plaque mince (1,2),
- il est connecté audit cadre (2) par quatre bras de liaison (11) situés de part et d'autre dudit résonateur dans le prolongement d'une de ses lignes nodales (10a, 10b), et
- il est excité pour osciller selon un mode de torsion non couplé.

2. Résonateur selon la revendication 1, caractérisé en ce que lesdits angles Θ et Ψ ont pour valeur -33° et 0°, respectivement.

3. Résonateur selon la revendication 1, caractérisé en ce que lesdits angles Θ et Ψ ont pour valeur + 34° et + 45°, respectivement.

4. Résonateur selon l'une quelconque des revendications 1 à 3, caractérisé en ce que le résonateur a une forme rectangulaire.

5. Résonateur selon l'une quelconque des revendications 1 à 3, caractérisé en ce que le résonateur a une forme carrée.

6. Résonateur selon l'une quelconque des revendications 1 à 3, caractérisé en ce que le résonateur a une forme de parallélogramme.

7. Résonateur selon l'une quelconque des revendications 1 à 3, caractérisé en ce que le résonateur a une forme elliptique.

8. Résonateur selon l'une quelconque des revendications 1 à 3, caractérisé en ce que le résonateur a une forme circulaire.

9. Résonateur à quartz (1) ayant une forme géométrique symétrique réalisée dans une plaque mince (1,2) et présentant de bonnes propriétés thermiques, ladite plaque mince étant obtenue par une rotation d'angle Θ autour de l'axe mécanique Y du cristal de quartz et l'axe de symétrie de ladite forme géométrique faisant avec ledit axe Y un angle Ψ; lesdits angles Θ et Ψ étant choisis de telle manière que le coefficient thermique de premier ordre a ait une valeur nulle ou voisine de zéro et le coefficient thermique de deuxième ordre β ait une valeur nulle ou très faible; ledit résonateur étant caractérisé en ce que :
- il présente une forme pleine et symétrique insérée dans un cadre (2) formé par ladite plaque mince (1,2),
- il est connecté audit cadre (2) par quatre bras de liaison (11) situés de part et d'autre dudit résonateur dans le prolongement d'une de ses lignes nodales (10a, 10b), et
- il est excité pour osciller selon un mode de torsion non couplé.

10. Résonateur selon la revendication 9, caractérisé en ce que lesdits angles Θ et Ψ ont des valeurs comprises entre + 33° à + 35° et + 65° à + 75°, respectivement.

11. Résonateur selon l'une quelconque des revendications 9 et 10, caractérisé en ce que le résonateur a une forme rectangulaire.

12. Résonateur selon l'une quelconque des revendications 9 et 10, caractérisé en ce que le résonateur a une forme carrée.

13. Résonateur selon l'une quelconque des revendications 9 et 10, caractérisé en ce que le résonateur a une forme de parallélogramme.

14. Résonateur selon l'une quelconque des revendications 9 et 10, caractérisé en ce que le résonateur a une forme elliptique.

15. Résonateur selon l'une quelconque des revendications 9 et 10, caractérisé en ce que le résonateur a une forme circulaire.

## Patentansprüche

1. Quarzresonator (1) mit symmetrischer geometrischer Form, hergestellt in einer dünnen Platte (1,2) und mit guten thermischen Eigenschaften, welche dünne Platte durch eine Drehung um den Winkel θ um die elektrische Achse X des Quarzkristalls erhalten wird, und wobei die Symmetrieachse der geometrischen Form mit der genannten Achse X einen Winkel Ψ bildet, welche Winkel θ und Ψ derart gewählt sind, daß der thermische Koeffizient erster Ordnung α einen Wert Null oder nahe bei Null annimmt und der thermische Koeffizient zweiter Ordnung β einen Wert Null oder sehr gering aufweist; welcher Resonator dadurch gekennzeichnet ist:
- daß er eine ebene und symmetrische Form aufweist, eingefügt in einen von der dünnen Platte (1,2) gebildeten Rahmen (2),
- daß er mit dem Rahmen (2) über vier Verbindungsarme (11) verbunden ist, die sich beidseits des Resonators in Verlängerungen einer seiner Knotenlinien (10a,10b) befinden, und
- daß er zur Schwingung gemäß einem nichtgekoppelten Torsionsmodus erregt ist.

2. Resonator nach Anspruch 1, dadurch gekennzeichnet, daß die Winkel θ und Ψ die Größen -33° bzw. 0° haben.

3. Resonator nach Anspruch 1, dadurch gekennzeichnet, daß die Winkel θ und Ψ die Werte +34° bzw. +45° haben.

4. Resonator nach einem der Ansprüche 1 bis 3, dadurch gekennzeichnet, daß der Resonator eine rechteckige Form aufweist,

5. Resonator nach einem der Ansprüche 1 bis 3, dadurch gekennzeichnet, daß der Resonator eine quadratische Form aufweist.

6. Resonator nach einem der Ansprüche 1 bis 3, dadurch gekennzeichnet, daß der Resonator eine Parallelogrammform aufweist.

7. Resonator nach einem der Ansprüche 1 bis 3, dadurch gekennzeichnet, daß der Resonator eine elliptische Form aufweist.

8. Resonator nach einem der Ansprüche 1 bis 3, dadurch gekennzeichnet, daß der Resonator eine kreisrunde Form aufweist.

9. Quarzresonator (1) mit symmetrischer geometrischer Form, hergestellt in einer dünnen Platte (1,2) und mit guten thermischen Eigenschaften, welche dünne Platte durch Drehung um den Winkel θ um die mechanische Achse Y des Quarzkristalls erhalten wird und die Symmetrieachse der geometrischen Form mit der genannten Achse Y einen Winkel Ψ bildet; welche Winkel θ und Ψ derart gewählt sind, daß der thermische Koeffizient erster Ordnung α einen Wert Null oder nahe bei Null annimmt und der thermische Koeffizient zweiter Ordnung β einen Wert Null oder sehr gering annimmt; welcher Resonator dadurch gekennzeichnet ist:
- daß er eine ebene und symmetrische Form aufweist, eingefügt in einen von der dünnen Platte (1,2) gebildeten Rahmen (2),
- daß er mit dem Rahmen (2) über vier Verbindungsarme (11) verbunden ist, die sich beidseits des Resonators in Verlängerungen einer seiner Knotenlinien (10a,10b) befinden, und
- daß er zur Schwingung gemäß einem nichtgekoppelten Torsionsmodus erregt ist.

10. Resonator nach Anspruch 9, dadurch gekennzeichnet, daß die Winkel θ und Ψ Werte zwischen +33° bis +35° bzw. +65° bis +75° haben.

11. Resonator nach einem der Ansprüche 9 und 10, dadurch gekennzeichnet, daß der Resonator eine rechteckige Form aufweist.

12. Resonator nach einem der Ansprüche 9 und 10, dadurch gekennzeichnet, daß der Resonator eine quadratische Form aufweist.

13. Resonator nach einem der Ansprüche 9 und 10, dadurch gekennzeichnet, daß der Resonator eine Parallelogrammform aufweist.

14. Resonator nach einem der Ansprüche 9 und 10, dadurch gekennzeichnet, daß der Resonator eine elliptische Form aufweist.

15. Resonator nach einem der Ansprüche 9 und 10, dadurch gekennzeichnet, daß der Resonator eine kreisrunde Form aufweist.

## Claims

1. A quartz resonator (1) having a symmetrical geometrical shape formed in a thin plate (1, 2) and exhibiting good thermal properties, the said thin plate being obtained by rotation through an angle Θ about the electrical axis X of the quartz crystal and the axis of symmetry of the said geometrical shape making an angle Ψ with the said axis X, the said angles Θ and Ψ being selected in such a manner that the coefficient of thermal expansion of first order α has a value of zero or close to zero and the coefficient of thermal expansion of second order β has a value of zero or a very small value; the said resonator being characterized in that:
- it has a solid and symmetrical shape fitted inside a frame (2) formed by the said thin plate (1, 2),
- it is connected to the said frame (2) by four connecting arms (11) located on one side and the other of the said resonator in extension of one of its nodal lines (10a, 10b), and
- it is excited to oscillate in an uncoupled torsional mode.

2. A resonator according to claim 1, characterized in that the said angles Θ and Ψ have values of -33° and 0° respectively.

3. A resonator according to claim 1, characterized in that the said angles Θ and Ψ have values of +34° and +45° respectively.

4. A resonator according to any one of claims 1 to 3, characterized in that the resonator has a rectangular shape.

5. A resonator according to any one of claims 1 to 3, characterized in that the resonator has a square shape.

6. A resonator according to any one of claims 1 to 3, characterized in that the resonator has a parallelogram shape.

7. A resonator according to any one of claims I to 3, characterized in that the resonator has an elliptical shape.

8. A resonator according to any one of claims 1 to 3, characterized in that the resonator has a circular shape.

9. A quartz resonator (1) having a symmetrical geometrical shape formed in a thin plate (1, 2) and exhibiting good thermal properties, the said thin plate being obtained by rotation through an angle Θ about the mechanical axis Y of the quartz crystal and the axis of symmetry of the said geometrical shape making an angle Ψ with the said axis Y, the said angles Θ and Ψ being selected in such a manner that the coefficient of thermal expansion of first order a has a value of zero or close to zero and the coefficient of thermal expansion of second order β has a value of zero or a very small value; the said resonator being characterized in that:
- it has a solid and symmetrical shape fitted inside a frame (2) formed by the said thin plate (1, 2),
- it is connected to the said frame (2) by four connecting arms (11) located on one side and the other of the said resonator in extension of one of its nodal lines (10a, 10b), and
- it is excited to oscillate in an uncoupled torsional mode.

10. A resonator according to claim 9, characterized in that the said angles Θ and Ψ have values lying between +33° and +35° and between +65° and +75° respectively.

11. A resonator according to claim 9 or 10, characterized in that the resonator has a rectangular shape.

12. A resonator according to claim 9 or 10, characterized in that the resonator has a square shape.

13. A resonator according to claim 9 or 10, characterized in that the resonator has a parallelogram shape.

14. A resonator according to claim 9 or 10, characterized in that the resonator has an elliptical shape.

15. A resonator according to claim 9 or 10, characterized in that the resonator has a circular shape.
